# EUROPEAN PATENT SPECIFICATION

(11) **EP 3 418 252 B1**
(45) Date of publication and mention of the grant of the patent: **16.11.2022**
(21) Application number: 17176769.2
(22) Date of filing: 20.06.2017
(51) Int. Cl.: G02F 1/13357, H01L 33/58, G02B 26/00, G02B 3/00, G02B 3/02, B82Y 20/00, C09D 11/101, B29D 11/00, H01L 33/50

(54) **QUANTUM DOT LIQUID LENS, DEVICES COMPRISING THE SAME, METHOD OF MANUFACTURING A QUANTUM DOT LIQUID LENS, AND METHOD OF OPERATING A LIGHT EMITTING ELECTRONIC DEVICE**
QUANTENPUNKTFLÜSSIGLINSE, VORRICHTUNGEN DAMIT, VERFAHREN ZUR HERSTELLUNG EINER QUANTENPUNKTFLÜSSIGLINSE UND VERFAHREN ZUM BETRIEB EINER LICHTEMITTIERENDEN ELEKTRONISCHEN VORRICHTUNG
LENTILLE LIQUIDE À POINTS QUANTIQUES, DISPOSITIFS LES CONTENANT, PROCÉDÉ DE FABRICATION D'UNE LENTILLE LIQUIDE À POINTS QUANTIQUES ET PROCÉDÉ DE FONCTIONNEMENT D'UN DISPOSITIF ÉLECTRONIQUE ÉLECTROLUMINESCENT

(43) Date of publication of application: 26.12.2018
(73) Proprietor: Vestel Elektronik Sanayi ve Ticaret A.S., 45030 Manisa (TR)
(72) Inventor: ÖZAYDIN, Mustafa Caglar, 45030 Manisa (TR); ELIBOL, Metehan, 45030 Manisa (TR)
(74) Representative: Kehl, Ascherl, Liebhoff & Ettmayr Patentanwälte Partnerschaft mbB

(56) References cited:
- WO-A1-2007/113637
- US-A1- 2009 002 806
- US-B1- 6 369 954

## Description

The present invention relates to a lens according to claim 1, a light emitting electronic device according to claim 9, a backlight for a display screen according to claim 12, a luminaire according to claim 13, a method of manufacturing a lens according to claim 14 and a method of operating a light emitting electronic device according to claim 15.

### Background of the Invention

It is known to provide display screens, such as video display screens, with backlights to enhance their brightness. Such backlights generally comprise a plurality of light emitting electronic devices, which themselves each comprise a light emitting diode (LED) and associated optics, such as a total internal reflection (TIR) lens. However, such traditional backlights suffer from several problems, as follows: uneven illumination of the display, inflexibility of their manufacturing process to adapt the design of the optics, and low colour gamut of the light they produce.

Technical background to the present invention may be found in a white paper by B. Berge: "The Liquid Lens Technology - How it Works and What it is Doing", published by Varioptic S.A. of Lyon, France (2 December 2010). Liquid lenses work on the physical principle of electrowetting. Some examples of liquid lenses are described in EP 1 991 890 A, EP 1 736 802 A and EP 1870 741 A.

US-A-2009/0002806 describes a portable electronic device having an electrowetting display illuminated by quantum dots.

US6369954 describes an electrowetting lens, potentially coloured, but is silent about the specific use of quantum dots, let alone of a quantum dots solution with a double peak size distribution.

### Object of the Invention

It is therefore an object of the invention to provide a lens, a light emitting electronic device, a backlight for a display screen, a luminaire, a method of manufacturing a lens, and a method of operating a light emitting electronic device.

### Description of the Invention

The object of the invention is solved by a lens according to claim 1. The lens at least comprises a transparent liquid with quantum dots suspended therein, wherein the quantum dots transmit visible light of a longer wavelength than they receive, the quantum dots have a size distribution comprising at least two peaks, and a surface profile of the transparent liquid can be changed in shape by electrowetting, such that one or more optical properties of the lens is dynamically altered during transmission of light thereby.

This solution is beneficial because the quantum dots suspended in the transparent liquid can be used to down-convert the wavelength of light transmitted through the lens, and the shape, size, composition and concentration of the quantum dots may be varied to modify the optical properties of the lens, and in particular to modify the colour gamut of light transmitted by the lens. This solution is also beneficial because it can be used to create a spectral distribution of light transmitted by the lens having a plurality of emission peaks, each of which corresponds to one of the peaks in the size distribution of the quantum dots.

Advantageous embodiments of the invention may be configured according to any claim and/or part of the following description.

Liquid lenses of the prior art generally comprise two immiscible transparent liquids, one of which is electrically insulating (such as an oil) and one of which is electrically conducting (such as an electrolytic solution).

In one possible preferred embodiment, therefore, the transparent liquid in which the quantum dots are suspended is an electrolytic solution. Alternatively, however, the transparent liquid in which the quantum dots are suspended may be an electrically insulating liquid. Each possible alternative has its own benefits according to the chemical and microphysical properties of the quantum dots and the chemical properties of the transparent liquid in which they are suspended, and according to how the quantum dots and the transparent liquid in which they are suspended interact with each other. These different benefits can be determined by experiment.

Preferably, the density of the quantum dots is substantially the same as the density of the transparent liquid in which they are suspended. This solution is beneficial because it renders the quantum dots neutrally buoyant in the transparent liquid in which they are suspended and helps to ensure that they do not settle out from the transparent liquid under gravity.

Preferably, the lens comprises a plurality of immiscible transparent liquids, in the manner of liquid lenses of the prior art, but differing therefrom in that at least one of the transparent liquids has quantum dots suspended therein. This solution is beneficial because it allows all the properties and behavioural characteristics of liquid lenses of the prior art to be adapted thereto. However, the lens may alternatively comprise only a single transparent liquid having quantum dots suspended therein, for example, if the optical properties of the lens are intended to remain fixed after its manufacture, rather than to be dynamically variable.

If the lens does comprise a plurality of immiscible transparent liquids, at least two of the plurality of immiscible transparent liquids may each have quantum dots suspended therein, and the quantum dots suspended in one of the immiscible transparent liquids may have one or more of a different size, shape, composition and concentration from those of the quantum dots suspended in another of the immiscible transparent liquids. Thus, for example, one of the immiscible transparent liquids may have quantum dots adapted to down-convert blue light into green light suspended therein and the other of the immiscible transparent liquids may have quantum dots adapted to down-convert blue light into red light suspended therein.

The present invention also relates to a light emitting electronic device at least comprising a light-emitting diode (LED) and a lens as described herein. Preferably, the LED is a blue LED and the quantum dots have a size distribution comprising two peaks configured to transmit light at green and red wavelengths. This solution is beneficial because the blue light emitted by the LED can be down-converted by the quantum dots within the lens to provide green and red light, which mix with the blue light from the LED to provide white light with a high colour gamut.

Preferably, the light emitting electronic device further comprises one or more electrodes arranged to change a surface profile of the transparent liquid in which the quantum dots are suspended by electrowetting. This solution is beneficial because it allows one or more optical properties of the light emitting electronic device to be altered during emission of light thereby by changing a surface profile of the transparent liquid.

The present invention further relates to a backlight for a display screen, such as a video display screen or a static poster display, at least comprising a plurality of light emitting electronic devices as described herein. This solution is beneficial since the liquid lenses of the light emitting electronic devices in the backlight can be dynamically altered in shape, so that the light they transmit can be directed as desired, and problems with uneven illumination of the display screen described above can thereby be greatly reduced or eliminated entirely.

In addition, the present invention relates to a luminaire. The luminaire at least comprises a plurality of light emitting electronic devices as described herein, each of which comprises one or more electrodes arranged to change a surface profile of the transparent liquid in which the quantum dots are suspended by electrowetting, and user-operable electronics electrically connected to the one or more electrodes, whereby at least one optical property of one or more of the light emitting electronic devices can be controlled. Such a luminaire may be used to provide colourful, aesthetically attractive and dynamically changing illumination, for example a different colour temperature at different times of day.

The present invention also relates to a method of manufacturing a lens. The method at least comprises suspending quantum dots which transmit visible light of a longer wavelength than they receive and have a size distribution comprising at least two peaks in a transparent liquid, sealing the transparent liquid within a cell, and providing the cell with one or more electrodes arranged to change a surface profile of the transparent liquid within the cell by electrowetting, such that one or more optical properties of the lens is dynamically altered during the transmission of light thereby.

This solution is beneficial because it allows the shape, and therefore a wide range of optical properties, of the lens to be altered by changing the surface profile of the transparent liquid in which the quantum dots are suspended, rapidly (in only a few milliseconds), and even during transmission of light by the lens.

Moreover, the present invention also relates to a method of operating a light emitting electronic device as described herein, when the device comprises one or more electrodes arranged to change a surface profile of the transparent liquid by electrowetting. The method at least comprises altering an optical property of the light emitting electronic device during emission of light thereby by changing a surface profile of the transparent liquid.

Further features, goals and advantages of the present invention will now be described in association with the accompanying drawings, in which exemplary components of the invention are illustrated. Components of the devices and methods according to the invention which are at least essentially equivalent to each other with respect to their function can be marked by the same reference numerals, wherein such components do not have to be marked or described in all of the drawings.

In the following description, the invention is described by way of example only with respect to the accompanying drawings.

### Brief Description of the Drawings

Fig. 1A is a close-up photograph of part of an edge-type backlight illumination strip of the prior art mounted in an enclosure for a video display screen;
Fig. 1B is a schematic diagram of a first possible location of the edge-type backlight illumination strip of Fig. 1A in an enclosure for a video display screen;
Fig. 1C is a schematic diagram of a second possible location of the edge-type backlight illumination strip of Fig. 1A in an enclosure for a video display screen;
Fig. 2A is a photograph from the rear of a back panel of an enclosure for a direct-type of backlight illumination unit of the prior art;
Fig. 2B is a schematic diagram of a direct-type of backlight illumination unit of the prior art for a video display screen;
Fig. 3A is a first photograph showing a plan view of a total internal reflection optical element of the prior art;
Fig. 3B is a second photograph showing a perspective view of the total internal reflection optical element shown in Fig. 3A;
Fig. 4 is a schematic diagram showing a cross-sectional view of a total internal reflection optical element of the prior art;
Fig. 5A is a photograph of two halves of a mould used in the manufacture of several total internal reflection optical elements of the type shown in Figs 3A, 3B and 4;
Fig. 5B is a photograph of several total internal reflection optical elements of the prior art after their release from a mould such as that shown in Fig. 5A;
Fig. 6 is a graph showing the angular distribution of light transmitted by a total internal reflection optical element of the type shown in Figs. 3A to 5B;
Fig. 7A is a photograph from the rear of a back panel of an enclosure of a video display screen of the prior art, showing angles of elements of the back panel;
Fig. 7B is a photograph of a video display screen showing a typical example of its illumination by a direct-type of backlight illumination;
Fig. 8A is a CIE 1931 colour chart showing the typical colour values of white light emitted by an LED of the prior art;
Fig. 8B is a graph showing a typical example of the spectral distribution of white light emitted by an LED of the prior art;
Fig. 9 is a graph showing how the spectral distribution of white light emitted by an LED of the prior art may by modified by a K₂SiF₆ phosphor;
Fig. 10 is a graph showing the normalized emission intensity of five quantum dots of different sizes;
Fig. 11 is a schematic perspective view of a light emitting electronic device according to an embodiment of the invention; and
Fig. 12 is a graph showing a typical example of the spectral distribution of light transmitted by a quantum dot lens according to an embodiment of the invention.

### Detailed Description of the Drawings

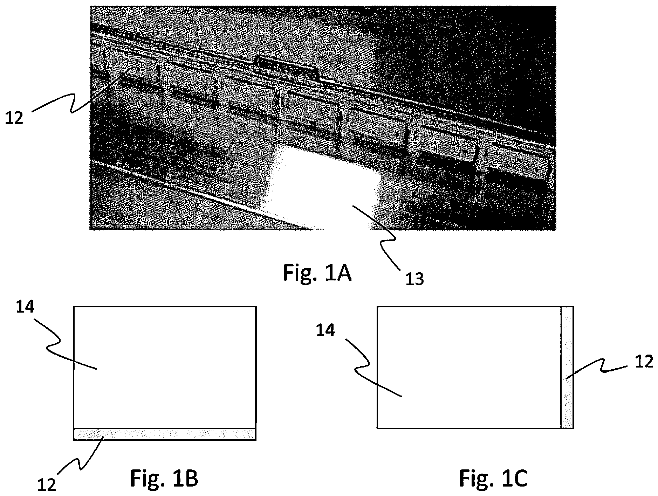

Fig. 1A is a close-up photograph of part of an edge-type backlight illumination strip 12 of the prior art mounted in an enclosure 13 for a video display screen 14. Such an edge-type backlight illumination strip 12 comprises a plurality of light emitting electronic devices, which are typically light emitting diodes (LEDs), together with their associated optics. The backlight illumination strip 12 may be mounted within the display screen enclosure 13 either along a horizontal edge thereof, as shown in Fig. 1B, or along a vertical edge thereof, as shown in Fig. 1C, or a combination of both. This edge type of backlight illumination has the disadvantage that light injected at the edge of the display screen must be guided in a complicated manner to try and ensure evenly distributed illumination of the display screen from its edges all the way to the centre of the display screen, which requires very sophisticated design and manufacturing techniques, which are not always possible. Corners or edges of the screen can therefore appear brighter than the centre thereof.

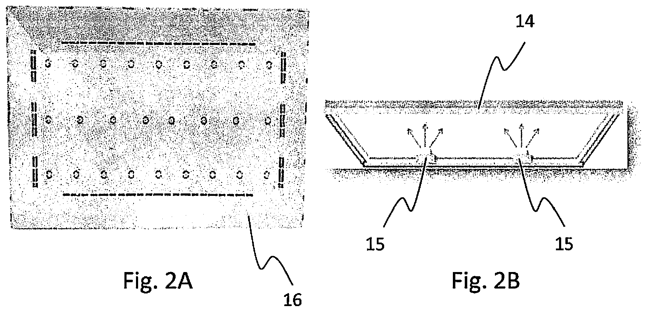

Fig. 2A is a photograph from the rear of a back panel 16 of an enclosure for a direct-type of backlight illumination unit. As may be seen from Fig. 2A, the back panel 16 is sufficiently deep to allow a direct-type of backlight illumination unit of the type shown in Fig. 2B to be mounted therein behind a video display screen. This direct-type of backlight illumination comprises one or more light-emitting electronic devices 15, such as light emitting diodes (LEDs), and their associated optics, which are oriented to direct light onto the rear of the video display screen 14, instead of at its edges.

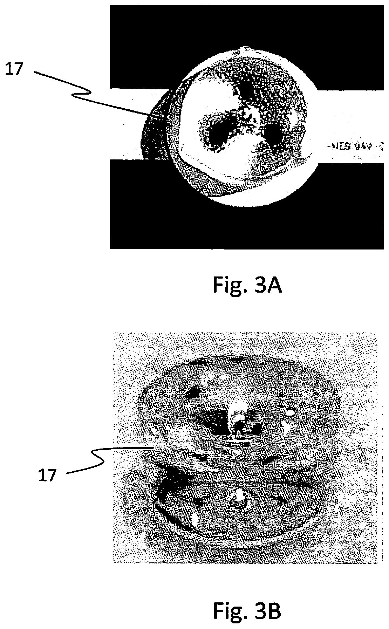

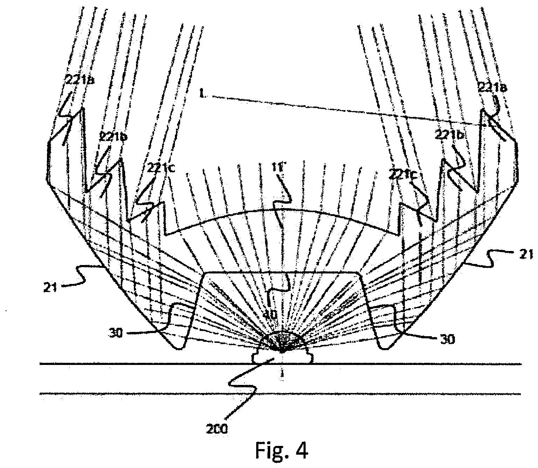

Figs. 3A and 3B are two photographs of a total internal reflection (TIR) optical element 17 which is an optic of the type used in the prior art in such a direct-type light-emitting electronic device 15, in association with an LED. Fig. 4 schematically shows a cross-sectional view of such a TIR optical element 17, as described in EP 2 835 575 A, for the purposes of illustrating how such a TIR optical element 17 works. Light emitted by LED 200 enters the TIR optical element 17 through central refractive surface 30 and lateral refractive surfaces 40. Whereas rays of light from the LED 200 emitted in the direction of optical axis 11 pass straight through the optical element 17, other rays of light are refracted by the central and lateral refractive surfaces 30, 40 as shown in Fig. 4 and are subject to total internal reflection from reflective surfaces 21, before exiting the optical element 17 via steps of a Fresnel zone plate 221a, 221b, 221c. The light from LED 200 is thus redirected in a range of angles as desired.

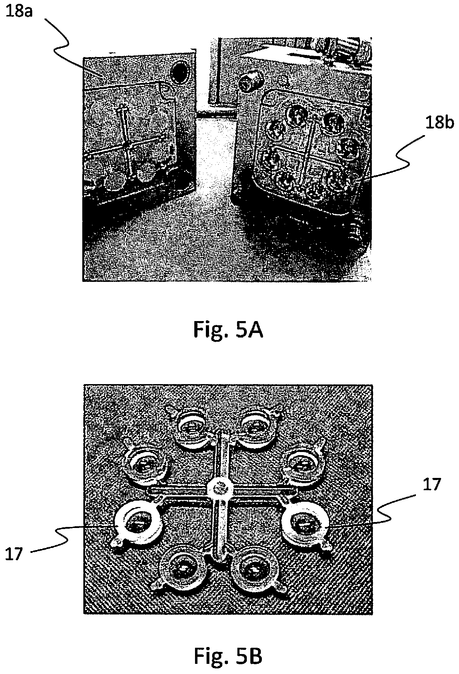

Fig. 5A is a photograph of two halves 18a, 18b of a mould which may be used to manufacture several TIR optical elements 17 of the type shown in Figs 3A, 3B and 4. Such lens moulds may be acquired, for example, from Darkoo Optics (Zhongshan) Co., Ltd. of Zhongshan City, Guangdong, China with model number DK4224-JC. The mould may be injected with a transparent plastics material, such as poly(methyl methacrylate) (PMMA), to produce a moulding comprising a plurality of such TIR optical elements 17 joined together by webbing, as shown in Fig. 5B. The TIR optical elements 17 may then be separated from the webbing for subsequent use. Such a manufacturing technique has the disadvantage that once the shape of the lens has been designed and the moulds created, the shape of the lens cannot be quickly and easily changed, without making new moulds. Moulding of this type is also inherently a batch production process, producing one batch of lens from each moulding operation, which is slower than a continuous production process.

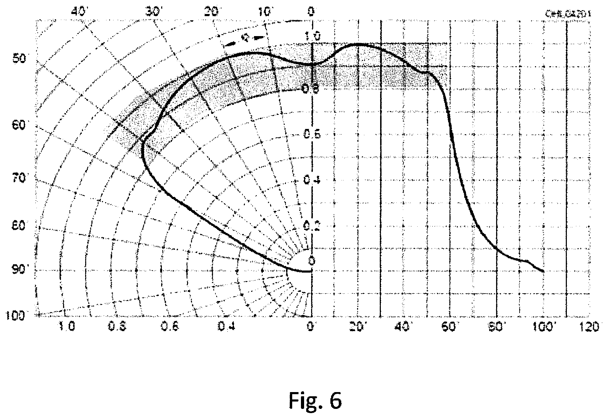

Fig. 6 is a graph showing the angular distribution of light transmitted by a TIR optical element 17 of the type shown in Figs. 3A to 5B, plotted in polar co-ordinates on the lefthand side of Fig. 6 and in linear co-ordinates on the right-hand side of Fig. 6. As may be seen, the angular distribution of light transmitted by the TIR optical element 17 covers a range of from zero up to about 55 degrees, as highlighted in Fig. 6 by the shaded zone of the graph, before falling off rapidly.

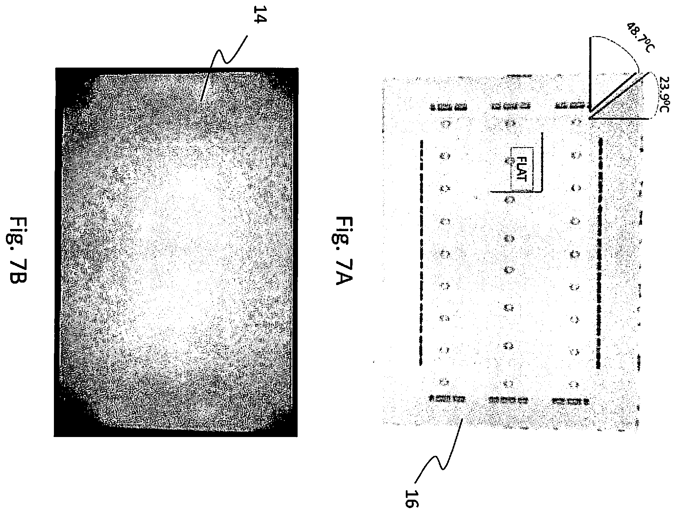

Fig. 7A is a photograph again showing the rear of the back panel 16 of an enclosure for a video display screen, but now marked with angles of elements of the back panel 16 as indicated in Fig. 7A. The combination of these angles with the angular distribution of light transmitted by a TIR optical element 17 as shown in Fig. 6 is used in the direct type of backlight illumination of the prior art to try and illuminate the video display screen more evenly than edge-type backlight illumination. However, even with such direct-type backlighting, illumination of the display screen can remain very uneven, as shown by the photograph of Fig. 7B.

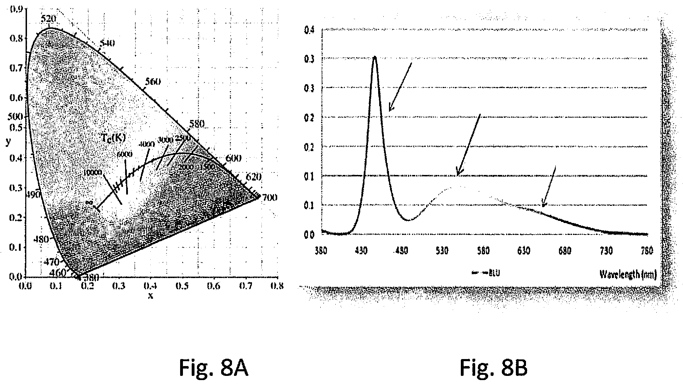

Fig. 8A is an International Commission on Illumination (CIE) 1931 colour chart showing the typical colour values of white light emitted by an example LED of the prior art. The emitted light has Cx and Cy colour values which give a colour temperature of about 9300 K, as an example. This corresponds to a typical spectral distribution as represented in the graph of Fig. 8B. The spectral distribution has one larger, narrower emission peak and two lower, broader emission peaks at the wavelengths indicated in Fig. 8B by the arrows, which roughly correspond to the wavelengths of blue, green and red light, respectively. The gamut value of this spectral distribution is 72% CIE 1931. Transmitting light with this spectral distribution through a lens of the type shown in Figs 3A, 3B and 4 does not change this gamut value at all.

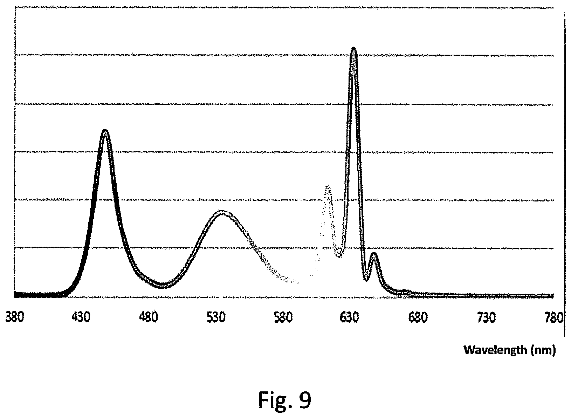

Fig. 9 is a graph showing how the spectral distribution of white light emitted by an LED of the type shown in Figs. 8A and 8B may by modified by a K₂SiF₆ phosphor (also known as a KSF phosphor). An example of such a KSF phosphor is described in US 2012/0299466. The KSF phosphor can increase the height of the longest wavelength (red) emission peak relative to that of the other two peaks as shown in Fig. 9, and can therefore also increase the gamut value achievable up to about 90% CIE 1931. However, the overall spectral distribution still remains somewhat uneven, and a gamut value of 100% remains unachieved.

In summary, therefore, the different display backlighting techniques of the prior art suffer from several drawbacks as follows: uneven display illumination, an insufficiently high colour gamut value, and inflexible and costly manufacturing techniques.

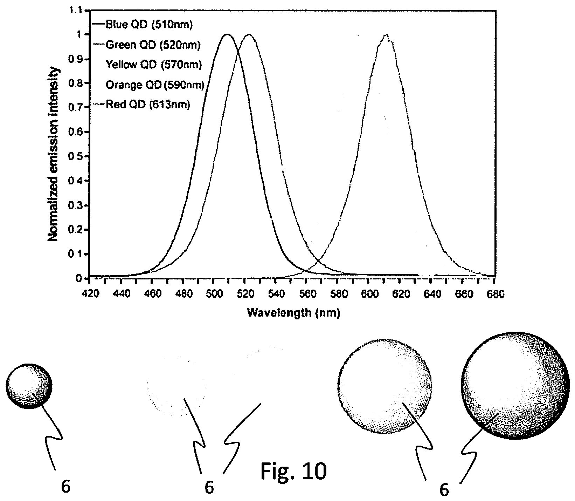

Fig. 10 is a graph showing the normalized emission intensity of five quantum dots of different sizes. A quantum dot is a nanoscale particle whose physical properties vary according to their size and shape. Thus the optical properties of a quantum dot, including the wavelength at which it transmits light, can be varied by altering its size and shape. Fig. 10 therefore shows how larger quantum dots emit light of longer wavelengths than smaller ones, and gives examples of emission peaks at five different wavelengths for differently sized quantum dots.

According to the invention, a lens may be manufactured by suspending quantum dots, such as those shown in Fig. 10, which transmit visible light of a longer wavelength than they receive, in a transparent liquid, and sealing the transparent liquid within a cell, whilst also providing the cell with one or more electrodes arranged to change a surface profile of the transparent liquid within the cell by electrowetting.

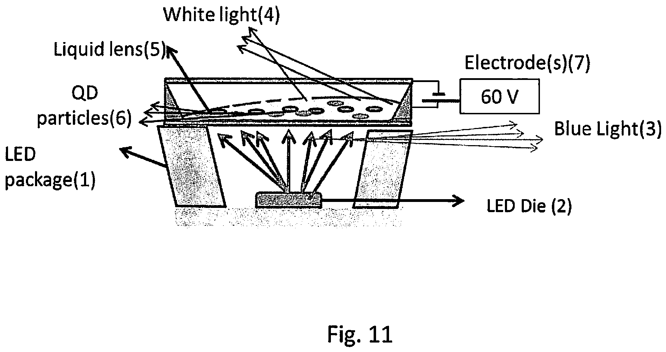

Fig. 11 therefore schematically shows an embodiment of a light emitting electronic device comprising such a lens. The light emitting electronic device comprises an LED die 2 mounted on a substrate within an LED package 1, onto which a liquid lens 5 is mounted. The liquid lens 5 comprises a transparent liquid, in which quantum dots 6 are suspended. The quantum dots transmit visible light of a longer wavelength than they receive.

Examples of conventional liquid lenses, which do not comprise any quantum dots, can be acquired from Varioptic, Invenios France SAS of Lyon, France, such as their Arctic^{™}, Baltic^{™} and Caspian^{™} ranges of liquid lenses. Such liquid lenses generally comprise two immiscible transparent liquids, one of which is electrically insulating (such as an oil) and one of which is electrically conducting (such as an electrolytic solution). According to the invention, the quantum dots 6 may be suspended in either one or both of these two immiscible transparent liquids. In this embodiment, the density of the quantum dots 6 is chosen to be substantially the same as the density of the transparent liquid in which they are suspended, so that the quantum dots 6 are neutrally buoyant and do not settle out under gravity.

In the illustrated embodiment, the LED die 2 is a blue LED, which therefore emits blue light 3. The quantum dots 6 have a size distribution comprising two peaks configured to transmit light at green and red wavelengths. The blue light 3 therefore enters the liquid lens 5, where it is down-converted and re-emitted as light of longer wavelengths by the quantum dots 6 within the lens 5 to provide green and red light. These mix with the blue light 3 from the LED to create white light 4 with a high colour gamut.

In alternative possible embodiments, however, not illustrated in Fig. 11, immiscible transparent liquids may each have quantum dots suspended therein, and the quantum dots suspended in one of the immiscible transparent liquids may have one or more different properties from the quantum dots suspended in the other of the immiscible transparent liquids, such as their size, shape, composition and/or concentration.

Returning to the embodiment illustrated in Fig. 11, however, it may be seen that the light emitting electronic device further comprises one or more electrodes 7, which are arranged to change a surface profile of the transparent liquid by electrowetting. One of these electrodes is electrically connected to the electrolytic solution in the liquid lens, and another of these electrodes is separated from the electrically insulating transparent liquid by a thin insulating layer. Varying a voltage across these two electrodes over a range typically of from about 30 volts up to about 100 volts changes the surface profile of the boundary between the two immiscible transparent liquids, thereby changing one or more of their optical properties, such as their focal length, Gaussian (monochromatic) aberrations or chromatic aberration. More than two electrodes can be disposed around the liquid lens in pairs in order to change higher order optical aberrations of the lens in a manner known to a person of ordinary skill in the art of conventional liquid lenses, which do not comprise any quantum dots.

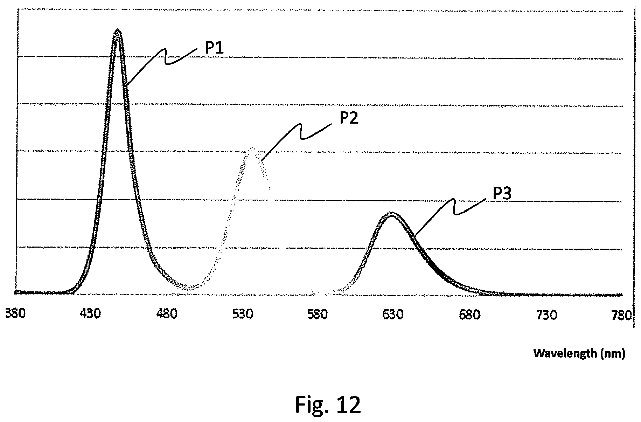

Fig. 12 is a graph showing how the spectral distribution of the blue light 3 emitted by the LED 2 in the light emitting electronic device of Fig. 11 is transmitted by the liquid lens 5 with quantum dots suspended therein. In comparison to those shown in Figs. 8B and 9, the spectral distribution of the light transmitted by the liquid lens 5 has three distinct and well-defined emission peaks, P1, P2, P3. The emission peak P1 is the blue light 3 emitted by the LED die 2 itself, whereas the emission peaks P2 and P3 are those created by the quantum dots 6 in the liquid lens 5. These peaks can all be finely adjusted by tuning the wavelength of the LED 2 and by varying the size, shape, composition and concentration of the quantum dots 6 to correspond exactly to the desired wavelengths of blue, green and red light, respectively. The gamut value of this spectral distribution is therefore 98.2% CIE 1931, which is significantly greater than that which can be achieved with a traditional white LED and a KSF phosphor, as shown, for example, in Fig. 9.

Moreover, since the liquid lens 5 with quantum dots suspended therein can be dynamically altered in shape during emission of light by the light emitting electronic device, by changing a surface profile of the transparent liquid which contains the quantum dots 6, a plurality of such lenses of different shapes at different times and/or comprising quantum dots with different physical properties from each other may easily be created to provide a luminaire with dynamically changing emission properties. If such a luminaire is also provided with user-operable electronics electrically connected to the one or more electrodes 7, at least one optical property of one or more of the light emitting electronic devices can be controlled by a user as desired.

A plurality of such light emitting electronic devices as described above may also be used as component parts of a backlight for a display screen, such as a video display screen or a static advertising poster display. Since the liquid lenses of the light emitting electronic devices in the backlight can be dynamically altered in shape as described, the light they transmit can be directed as desired, and the problems with uneven illumination of the display screen described above in relation to Figs. 6 to 7B can thereby also be greatly reduced or eliminated entirely.

In summary, the present invention provides a lens at least comprising a transparent liquid with quantum dots suspended therein, wherein the quantum dots transmit visible light of a longer wavelength than they receive. A surface profile of the transparent liquid may be changed in shape using the principle of electrowetting by electrically connecting electrodes to the lens, so that one or more optical properties of the lens may be dynamically altered during the transmission of light thereby. The quantum dots suspended in the transparent liquid can be used to down-convert the wavelength of light transmitted through the lens, and any of the shape, size, composition and concentration of the quantum dots may be varied to modify the optical properties of the lens, and in particular to modify the colour gamut of light transmitted by the lens. Thus, for example, the liquid lens can be combined with a blue LED in a light emitting electronic device, and the quantum dots can be chosen to have a size distribution comprising two peaks configured to transmit light at green and red wavelengths. The blue light emitted by the LED can therefore be down-converted by the quantum dots within the lens to provide green and red light, which mix with the blue light from the LED to provide white light with a high colour gamut. The present invention also provides a method of manufacturing such a lens, a method of operating a light emitting electronic device comprising such a lens, as well as a backlight for a display screen comprising a plurality of such light emitting electronic devices, and a luminaire also comprising a plurality of such light emitting electronic devices. Both the backlight for a display screen and the luminaire may therefore have their optical properties dynamically altered during emission of light thereby.

**Reference Numerals:**

| | | | |
|---|---|---|---|
| 1 | LED package | 16 | Rear panel of video display screen enclosure |
| 2 | LED die | | |
| 3 | Blue light emitted by LED die | 17 | LED lens |
| 4 | White light | 18a, 18b | Two halves of mould |
| 5 | Liquid lens doped with quantum | | |
| | dots | 21 | Reflective surface |
| 6 | Quantum dots | 30 | Central refractive surface |
| 7 | Electrode(s) | 40 | Lateral refractive surface |
| 11 | Optical axis | 200 | LED |
| 12 | Edge-type backlight strip | 221a, 221b, 221c | Steps of Fresnel zone plate |
| 13 | Enclosure of video display screen | | |
| 14 | Video display screen | P1, P2, P3 | Emission peaks |
| 15 | Direct-type backlight light-emitting device | | |

## Claims

1. A lens (5) at least comprising a transparent liquid with quantum dots (6) suspended therein, wherein the quantum dots transmit visible light of a longer wavelength than they receive, the quantum dots (6) have a size distribution comprising at least two peaks, and a surface profile of the transparent liquid can be changed in shape by electrowetting, such that one or more optical properties of the lens is dynamically altered during the transmission of light thereby.

2. A lens according to claim 1, wherein the transparent liquid is an electrolytic solution.

3. A lens according to claim 1, wherein the transparent liquid is an electrically insulating liquid.

4. A lens according to any one of the preceding claims, wherein the density of the quantum dots (6) is substantially the same as the density of the transparent liquid in which they are suspended.

5. A lens according to any one of the preceding claims, wherein the lens comprises a plurality of immiscible transparent liquids, at least one of which has quantum dots (6) suspended therein.

6. A lens according to claim 5, wherein at least two of the plurality of immiscible transparent liquids each have quantum dots (6) suspended therein, and the quantum dots suspended in one of the immiscible transparent liquids have one or more of a different size, shape, composition and concentration from those of the quantum dots suspended in another of the immiscible transparent liquids.

7. A light emitting electronic device at least comprising an LED (2) and a lens (5) according to any one of the preceding claims.

8. A light emitting electronic device according to claim 7, wherein the LED (2) is a blue LED and the quantum dots (6) have a size distribution comprising two peaks configured to transmit light at green and red wavelengths.

9. A light emitting electronic device according to claim 6 or claim 8, further comprising one or more electrodes (7) arranged to change a surface profile of the transparent liquid by electrowetting.

10. A backlight for a display screen at least comprising a plurality of light emitting electronic devices according to any one of claims 7 to 9.

11. A luminaire at least comprising a plurality of light emitting electronic devices according to claim 9 and user-operable electronics electrically connected to the one or more electrodes (7), whereby at least one optical property of one or more of the light emitting electronic devices can be controlled.

12. A method of manufacturing a lens, wherein the method at least comprises:
suspending quantum dots (6) which transmit visible light of a longer wavelength than they receive and have a size distribution comprising at least two peaks in a transparent liquid;
sealing the transparent liquid within a cell; and
providing the cell with one or more electrodes (7) arranged to change a surface profile of the transparent liquid within the cell by electrowetting, such that one or more optical properties of the lens is dynamically altered during the transmission of light thereby.

13. A method of operating a light emitting electronic device according to claim 9, wherein the method at least comprises altering an optical property of the light emitting electronic device during emission of light thereby by changing a surface profile of the transparent liquid.

## Patentansprüche

1. Linse (5), die mindestens eine transparente Flüssigkeit mit darin suspendierten Quantenpunkten (6) aufweist, wobei die Quantenpunkte sichtbares Licht einer längeren Wellenlänge aussenden als sie aufnehmen, die Quantenpunkte (6) eine Größenverteilung aufweisen, die mindestens zwei Peaks umfasst, und ein Oberflächenprofil der transparenten Flüssigkeit durch Elektrobenetzung in seiner Form verändert werden kann, so dass eine oder mehrere optische Eigenschaften der Linse während der Übertragung von Licht dadurch dynamisch verändert werden.

2. Linse gemäß Anspruch 1, wobei die transparente Flüssigkeit eine elektrolytische Lösung ist.

3. Linse gemäß Anspruch 1, wobei die transparente Flüssigkeit eine elektrisch isolierende Flüssigkeit ist.

4. Linse gemäß einem der vorhergehenden Ansprüche, wobei die Dichte der Quantenpunkte (6) im Wesentlichen die gleiche ist wie die Dichte der transparenten Flüssigkeit, in der sie suspendiert sind.

5. Linse gemäß einem der vorhergehenden Ansprüche, wobei die Linse eine Vielzahl von nicht-mischbaren transparenten Flüssigkeiten aufweist, von denen mindestens eine Quantenpunkte (6) enthält.

6. Linse gemäß Anspruch 5, wobei mindestens zwei der mehreren nicht mischbaren transparenten Flüssigkeiten jeweils Quantenpunkte (6) darin suspendiert haben und die Quantenpunkte, die in einer der nicht mischbaren transparenten Flüssigkeiten suspendiert sind, mindesten eines von einer unterschiedlichen Größe, Form, Zusammensetzung und Konzentration aufweisen als die Quantenpunkte, die in einer anderen der nicht mischbaren transparenten Flüssigkeiten suspendiert sind.

7. Lichtemittierende elektronische Vorrichtung, die zumindest eine LED (2) und eine Linse (5) gemäß einem der vorangehenden Ansprüche aufweist.

8. Lichtemittierende elektronische Vorrichtung gemäß Anspruch 7, wobei die LED (2) eine blaue LED ist und die Quantenpunkte (6) eine Größenverteilung aufweisen, die zwei Spitzen aufweist, die so konfiguriert sind, dass sie Licht mit grüner und roter Wellenlänge übertragen.

9. Lichtemittierende elektronische Vorrichtung gemäß Anspruch 6 oder Anspruch 8, die ferner eine oder mehrere Elektroden (7) aufweist, die so angeordnet sind, dass sie ein Oberflächenprofil der transparenten Flüssigkeit durch Elektrobenetzung verändern.

10. Hintergrundbeleuchtung für einen Display Bildschirm, die zumindest eine Vielzahl von lichtemittierenden elektronischen Vorrichtungen gemäß einem der Ansprüche 7 bis 9 aufweist.

11. Leuchte, die mindestens eine Vielzahl von lichtemittierenden elektronischen Vorrichtungen gemäß Anspruch 9 aufweist und eine vom Benutzer bedienbare Elektronik, die elektrisch mit der einen oder den mehreren Elektroden (7) verbunden ist, wodurch mindestens eine optische Eigenschaft einer oder mehrerer der lichtemittierenden elektronischen Vorrichtungen gesteuert werden kann.

12. Verfahren zur Herstellung einer Linse, wobei das Verfahren mindestens aufweist:
Suspendieren von Quantenpunkten (6), die sichtbares Licht mit einer längeren Wellenlänge aussenden als sie aufnehmen und eine Größenverteilung aufweisen, die mindestens zwei Spitzen aufweist, in einer transparenten Flüssigkeit;
Versiegeln der transparenten Flüssigkeit in einer Zelle; und
Bereitstellen von einer oder mehreren Elektroden (7) an der Zelle, die so angeordnet sind, dass sie ein Oberflächenprofil der transparenten Flüssigkeit innerhalb der Zelle durch Elektrobenetzung verändern, so dass eine oder mehrere optische Eigenschaften der Linse während der Übertragung von Licht dynamisch verändert werden.

13. Verfahren zum Betreiben einer lichtemittierenden elektronischen Vorrichtung gemäß Anspruch 9, wobei das Verfahren zumindest die Änderung einer optischen Eigenschaft der lichtemittierenden elektronischen Vorrichtung während der Emission von Licht durch diese aufweist, indem ein Oberflächenprofil der transparenten Flüssigkeit geändert wird.

## Revendications

1. Lentille (5) comprenant au moins un liquide transparent avec des points quantiques (6) en suspension dans celui-ci, dans laquelle les points quantiques transmettent la lumière visible d'une longueur d'onde plus longue que celle qu'ils reçoivent, les points quantiques (6) ont une distribution de taille comprenant au moins deux pics, et un profil de surface du liquide transparent peut être modifié en forme par électro mouillage, de sorte qu'une ou plusieurs propriétés optiques de la lentille sont dynamiquement modifiées pendant la transmission de la lumière par celle-ci.

2. Lentille selon la revendication 1, dans laquelle le liquide transparent est une solution électrolytique.

3. Lentille selon la revendication 1, dans laquelle le liquide transparent est un liquide électriquement isolant. 4.

4. Lentille selon l'une quelconque des revendications précédentes, dans laquelle la densité des points quantiques (6) est sensiblement la même que la densité du liquide transparent dans lequel ils sont en suspension.

5. Lentille selon l'une quelconque des revendications précédentes, dans laquelle la lentille comprend une pluralité de liquides transparents non miscibles, dont l'un au moins comporte des points quantiques (6) en suspension.

6. Lentille selon la revendication 5, dans laquelle au moins deux de la pluralité de liquides transparents non miscibles ont chacun des points quantiques (6) en suspension dans ceux-ci, et les points quantiques en suspension dans l'un des liquides transparents non miscibles ont une ou plusieurs tailles, formes, compositions et concentrations différentes de celles des points quantiques en suspension dans un autre des liquides transparents non miscibles.

7. Dispositif électronique émetteur de lumière comprenant au moins une LED (2) et une lentille (5) selon l'une quelconque des revendications précédentes.

8. Dispositif électronique émetteur de lumière selon la revendication 7, dans lequel la LED (2) est une LED bleue et les points quantiques (6) ont une distribution de taille comprenant deux pics configurés pour transmettre la lumière aux longueurs d'onde verte et rouge.

9. Dispositif électronique émetteur de lumière selon la revendication 6 ou la revendication 8, comprenant en outre une ou plusieurs électrodes (7) agencées pour modifier un profil de surface du liquide transparent par électro mouillage.

10. Rétroéclairage pour un écran d'affichage comprenant au moins une pluralité de dispositifs électroniques émetteurs de lumière selon l'une quelconque des revendications 7 à 9.

11. Luminaire comprenant au moins une pluralité de dispositifs électroniques émettant de la lumière selon la revendication 9 et une électronique utilisable par l'utilisateur connectée électriquement à une ou plusieurs électrodes (7), moyennant quoi au moins une propriété optique d'un ou plusieurs des dispositifs électroniques émettant de la lumière peut être contrôlée.

12. Une méthode de fabrication d'une lentille, dans laquelle la méthode comprend au moins :
la mise en suspension de points quantiques (6) qui transmettent de la lumière visible d'une longueur d'onde plus grande que celle qu'ils reçoivent et ont une distribution de taille comprenant au moins deux pics dans un liquide transparent ;
à enfermer le liquide transparent dans une cellule ; et
munir la cellule d'une ou plusieurs électrodes (7) agencées pour modifier un profil de surface du liquide transparent à l'intérieur de la cellule par électro mouillage, de telle sorte qu'une ou plusieurs propriétés optiques de la lentille soient dynamiquement modifiées pendant la transmission de la lumière par celle-ci.

13. Méthode de fonctionnement d'un dispositif électronique émetteur de lumière selon la revendication 9, dans laquelle la méthode comprend au moins la modification d'une propriété optique du dispositif électronique émetteur de lumière pendant l'émission de lumière par celui-ci en modifiant un profil de surface du liquide transparent.
